# EUROPEAN PATENT APPLICATION

(11) **EP 3 239 066 A1**
(43) Date of publication of application: **01.11.2017**
(21) Application number: 15872484.9
(22) Date of filing: 30.10.2015
(51) Int. Cl.: B65D 23/02, B32B 9/00, B65D 23/08, C23C 16/40, C23C 16/42

(54) **RESIN CONTAINER AND RESIN CONTAINER-COVERING DEVICE**

(30) Priority: 26.12.2014 JP 2014266270
(71) Applicant: Takemoto Yohki Co. Ltd., Tokyo 111-0036 (JP); Hirose, Fumihiko, Yonezawa-shi, Yamagata 992-0031 (JP)
(72) Inventor: HIROSE, Fumihiko, Yonezawa-shi Yamagata 992-0031 (JP); TAKEMOTO, Etsuko, Tokyo 111-0035 (JP); FUJIMORI, Hiroshi, Tokyo 111-0035 (JP); MASHIMA, Tsuyoshi, Tokyo 111-0035 (JP); SAKAMOTO, Hitoshi, Yokohama-shi Kanagawa 231-0005 (JP); ISHIBASHI, Kenichi, Yokohama-shi Kanagawa 231-0005 (JP)
(74) Representative: Grünecker Patent- und Rechtsanwälte PartG mbB
(86) International application number: PCT/JP2015/080827
(87) International publication number: WO 2016/103915

(57) **Abstract**

A resin container is provided having a dense and thin coating with good gas barrier properties and a resin-container coating apparatus. A metal oxide film is formed on at least one of inner and outer surfaces of a resin container. The metal oxide film includes a stack of layers of a metal forming the metal oxide film that are deposited on an atomic level. The metal oxide film and has a thickness of 5 to 100 nm.

## Description

### Technical Field

The present invention relates to resin containers and resin-container coating apparatuses.

### Background Art

Recently, packaging containers made of resins (resin containers) have been used in a variety of fields. Although resin containers are lighter and more impact-resistant than metal containers and glass containers, resin containers have the disadvantage of poor gas barrier properties.

Accordingly, research has been conducted on various coatings, among which silicon oxide coatings formed by plasma-enhanced CVD are known as coatings that can be deposited at relatively low temperatures and that have good gas barrier properties (see, for example, PTLs 1 to 3).

However, silicon oxide coatings formed by plasma-enhanced CVD are unsatisfactory in meeting the requirement of having sufficient gas barrier properties while being as thin as possible. A problem arises in that, since there are resin containers of various shapes and sizes, it is difficult to form a film with sufficient gas barrier properties on an inner surface of complicated shape by plasma-enhanced CVD. If such a film could be formed, a considerably thick film would need to be formed.

Metal oxide films formed by atomic layer deposition have also been known as dense coatings that have good gas barrier properties while being thin. In this method, a metal oxide film is formed on a substrate by placing the substrate on which a metal oxide is to be deposited in a reaction vessel and, while heating the substrate at about 250°C to 400°C, repeating the steps of filling the reaction vessel with a gasified organometallic, discharging the gas from the reaction vessel, introducing an oxidizing gas such as ozone or water vapor, and discharging the oxidizing gas. As the gasified organometallic is introduced into the reaction vessel, the substrate surface is exposed to the gas, and the organometallic adsorbs to saturation at an atomic level on the substrate surface. As the substrate is exposed to the oxidizing gas, the organometallic deposited on the substrate surface is oxidized to form a one-molecular-layer thick metal oxide film on the substrate surface. These steps, which are known as the ALD cycle, are repeated to form a metal oxide film having a thickness equivalent to the number of cycles. The substrate temperature is controlled to 250°C to 400°C for the following reason. Any higher temperature would result in a rapid decomposition reaction during the adsorption of the organometallic. Consequently, the thickness of molecules adsorbed after a single filling step would not reach saturation at one molecular layer, and a metal film, rather than a metal oxide film, would be finally formed. A temperature lower than 250°C causes a problem in that a metal oxide film itself cannot be deposited because of the decreased adsorption probability of the organometallic. Thus, this method has been inapplicable to resin containers.

### Citation List

### Patent Literature

PTL 1: Japanese Unexamined Patent Application Publication No. 2003-236976
PTL 2: Japanese Unexamined Patent Application Publication No. 2002-331606
PTL 3: Japanese Unexamined Patent Application Publication No. 2006-342423

### Summary of Invention

### Technical Problem

In view of the foregoing circumstances, a resin container is provided having a dense and thin metal oxide film with good gas barrier properties and a resin-container coating apparatus.

### Solution to Problem

A first aspect is a resin container having a metal oxide film formed on at least one of inner and outer surfaces thereof. The metal oxide film includes a stack of layers of a metal forming the metal oxide film that are deposited on an atomic level and has a thickness of 5 to 100 nm.

A second aspect is the resin container according to the first aspect, wherein the metal oxide film is deposited while the resin container is maintained at a temperature of greater than 0°C to less than or equal to 150°C.

A third aspect is the resin container according to the first or second aspect, wherein the metal oxide film includes a stack of atomic layers formed by oxidizing an organometallic adsorbed on the surface via hydroxy groups with a gas containing water vapor or oxygen and excited with plasma.

A fourth aspect is the resin container according to any one of the first to third aspects, wherein the metal forming the metal oxide film is selected from the group consisting of silicon, aluminum, gallium, germanium, titanium, zirconium, and zinc.

A fifth aspect is the resin container according to any one of the first to fourth aspects, wherein the metal oxide film is formed on the inner and outer surfaces of the resin container.

A sixth aspect is a resin-container coating apparatus including a reaction vessel in which a resin container is supported; a mechanism that maintains the temperature in the reaction vessel at greater than 0°C to less than or equal to 150°C; supply means for supplying an organometallic gas to the reaction vessel; plasma-gas supply means for introducing a gas containing water vapor or oxygen through a tube that leads to the reaction vessel and that is made of a dielectric including glass, the plasma-gas supply means including a mechanism that creates a radio-frequency magnetic field in and around the tube to generate plasma in the tube; and control means for repeating a step of diffusing the gasified organometallic supplied from the supply means to allow the organometallic to adsorb onto the resin container and a step of oxidizing the organometallic adsorbed on the resin container with the gas, containing water vapor or oxygen and excited with the plasma, supplied from the plasma-gas supply means.

### Brief Description of Drawings

[Fig. 1] Fig. 1 is a sectional view of a resin container according to one embodiment.
[Fig. 2] Fig. 2 is a sectional view of a resin container according to another embodiment.
[Fig. 3] Fig. 3 is a schematic illustration of a resin-container coating apparatus according to one embodiment for forming a metal oxide film on a resin container.
[Fig. 4] Fig. 4 is a schematic view of a water-vapor-gas generation unit and an activation unit according to one embodiment.
[Fig. 5] Fig. 5 is a graph showing results for the Examples.

### Description of Embodiments

The present invention will now be described in greater detail.

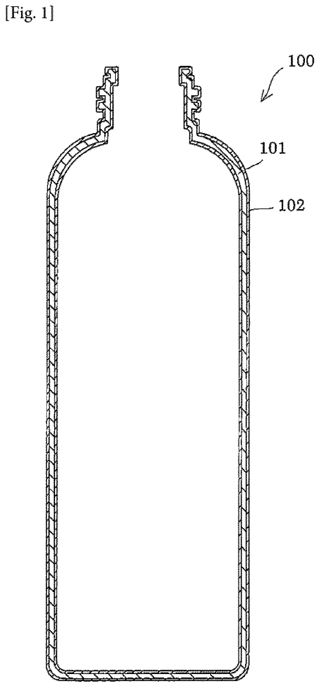

Fig. 1 shows a sectional view of a resin container according to one embodiment.

A resin container 100 according to this embodiment has a metal oxide film 102 formed on the surface of a resin container 101. The metal oxide film 102 according to this embodiment includes a stack of layers of a metal forming the metal oxide film that are deposited on an atomic level and has a thickness of 5 to 100 nm, preferably 8 to 30 nm. The metal oxide film 102 may be formed at least on the inner surface of the resin container 101. In this embodiment, the metal oxide film 102 is formed on all of the inner and outer surfaces.

The metal oxide film 102 is deposited by performing a first step of allowing a gasified organometallic to adsorb onto the surface of a container made of a resin, performing a second step of introducing water vapor or oxygen excited with plasma to the surface on which the organometallic is adsorbed to oxidize and decompose the adsorbed organometallic into a metal oxide and to form hydroxy groups on the surface thereof, and repeating the first and second steps. During the deposition process, the temperature in the reaction vessel is maintained at greater than 0°C to less than or equal to 150°C.

Although the structure of the metal oxide film 102 itself is that of a film formed by a known atomic layer deposition process, this method differs completely from conventional methods in that the temperature in the reaction vessel in which the resin container to be coated is placed is maintained at greater than 0°C to less than or equal to 150°C, preferably greater than 0°C to less than or equal to 100°C. The metal oxide film 102 is deposited as a dense film under such temperature conditions. Additionally, under such temperature conditions, the resin container does not deform thermally or experience a thermal stress.

The metal oxide film 102 is deposited by repeating the first step of allowing a gasified organometallic to adsorb onto the surface of the resin container and the second step of exposing the adsorbed organometallic to water vapor or oxygen excited with plasma to oxidize and decompose the organometallic into a metal oxide and to form hydroxy groups on the surface thereof. The adsorption of the organometallic may be performed by diffusing a gasified organometallic. The introduction of water vapor or oxygen excited with plasma to oxidize and decompose the adsorbed organometallic into a metal oxide may be performed by diffusing an excited gas. This method is advantageous in that the metal oxide film 102 can be easily deposited on the inner surface of a resin container of complicated shape, on the inner surface of a resin container having a narrow inlet, and at an inner edge of a resin container having a ridge and groove formed therein.

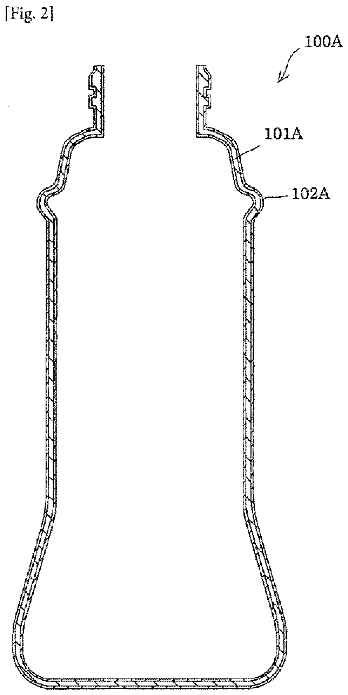

Fig. 2 shows a sectional view of a resin container according to another embodiment. A resin container 100A has a metal oxide film 102A formed on the surface thereof. A resin container 101A has a ridge and groove in the outer and inner surfaces thereof. The diffusion of a gasified organometallic allows the organometallic to adsorb uniformly onto the inner surface of the resin container 101A having a ridge and groove, so that the metal oxide film 102A can be densely and uniformly formed on the inner surface of the resin container 101A.

Thus, since the metal oxide film is densely and uniformly formed, the metal oxide film has better gas barrier properties than those formed by, for example, plasma-enhanced CVD. In addition, as discussed above, since the metal oxide film is deposited at a temperature of greater than 0°C to less than or equal to 150°C, preferably greater than 0°C to less than or equal to 100°C, the resin container does not deform thermally.

In conventional atomic layer deposition processes, if the substrate temperature during deposition (the temperature in the reaction vessel) falls below 250°C, a metal oxide cannot be deposited because of the decreased rate of adsorption of the organometallic onto the substrate surface. However, if hydroxy groups are formed on the surface of the resin container in advance, the organometallic can adsorb onto the surface of the resin container via the hydroxy groups at room temperature, i.e., about 10°C to 30°C. Accordingly, the adsorption of the organometallic in this embodiment is preceded by a step of forming hydroxy groups on the surface of the resin container at low temperature. Specifically, hydroxy groups are formed on the surface of the resin container in advance by exposure to water vapor with increased activity. The initial step of forming hydroxy groups does not have to be performed if the substrate to be coated readily adsorbs the organometallic or has hydroxy groups on the surface thereof.

Water vapor plasma with increased activity may contain OH molecules resulting from the decomposition of water, ionized water molecules, and monoatomic hydrogen, which add hydroxy groups to the surface of the resin container when exposed to the surface of the resin container.

Instead of water vapor plasma, hydroxy groups may be formed with oxygen plasma. The use of oxygen has the advantage of allowing deposition at room temperature; however, there is a risk of ignition and fire if the substrate to be coated is flammable. In contrast, the use of water vapor plasma has the advantage of effectively avoiding accidents such as ignition and fire.

A metal oxide thin film is formed on the surface of the resin container by placing the resin container 101 to be coated in a reaction vessel, maintaining the temperature in the reaction vessel at greater than 0°C to less than or equal to 150°C, preferably greater than 0°C to less than or equal to 100°C, and repeating a series of steps of initially filling the reaction vessel with a gasified organometallic and then introducing an oxidizing gas with increased activity, such as water vapor plasma. Since hydroxy groups are formed on the surface of the resin container, the organometallic can adsorb to saturation at room temperature. The oxidizing gas with increased activity is then introduced into the reaction chamber to oxidize and decompose the organometallic and to form hydroxy groups on the surface.

Whereas the method includes placing the resin container in a reaction vessel, maintaining the temperature in the reaction vessel at greater than 0°C to less than or equal to 150°C, preferably greater than 0°C to less than or equal to 100°C, and repeating a series of steps of filling the reaction vessel with a gasified organometallic and introducing an oxidizing gas with increased activity, such as water vapor plasma, the method may further include a step of filling the reaction vessel with ozone. This step is effective in removing surface hydrocarbons resulting from the adsorption of the organometallic and is therefore effective in reducing carbon remaining in the metal oxide film formed.

If employing a method for manufacturing a metal oxide film by placing the resin container in a reaction vessel, maintaining the temperature in the reaction vessel at greater than 0°C to less than or equal to 150°C, preferably greater than 0°C to less than or equal to 100°C, and repeating a series of steps of filling the reaction vessel with a gasified organometallic, introducing an oxidizing gas with increased activity, such as water vapor plasma, and introducing ozone, it is desirable to initially perform the step of introducing ozone, then perform the step of introducing water vapor with increased activity, then perform the step of filling the reaction vessel with a gasified organometallic, and subsequently repeat the above sequence. The initial treatment of the resin container with ozone is effective in oxidizing and removing any hydrocarbon and oil and fat that can be deposited as contaminants on the surface of the resin container, which results in improved gas barrier properties of the metal oxide film. After this treatment, a thin oxide film covers the surface of the resin container. The resin container is then treated with an oxidizing gas with increased activity to add hydroxy groups to the surface of the resin container. The step of filling the reaction vessel with a gasified organometallic is then performed to allow the organometallic to adsorb onto the surface of the resin container via the hydroxy groups. These steps are repeated in the above sequence. When the process ends after the metal oxide film is deposited to the target thickness, it is desirable to control the process so that the final step is the step of introducing ozone. Upon ozone treatment, the surface is inactive and does not readily adsorb impurity molecules such as hydrocarbon molecules because of the presence of bonds between metal atoms and oxygen, which is suitable for improving the gas barrier properties of the metal oxide film. If the process ends upon introduction of the gasified organometallic, hydrocarbons remain on the surface of the coating. These impurities would degrade the gas barrier properties of the metal oxide film. If the final step is the step of introducing the oxidizing gas with increased activity, hydroxy groups formed on the surface of the coating could make the coating hydrophilic and thus allow atmospheric moisture to adsorb onto the surface of the coating. It is not preferred that the process end at this step since water molecules are a factor that degrades the metal oxide film.

The resin that forms the resin container may be, for example, but not limited to, polyethylene, polypropylene, polyethylene terephthalate, polystyrene, acrylonitrile-styrene, or polyvinyl chloride.

The metal that forms the metal oxide film may be at least one metal selected from the group consisting of silicon, aluminum, gallium, germanium, titanium, zirconium, and zinc.

Examples of organometallics that may be used for deposition include various organometallic compounds that can be readily gasified, such as compounds in which carbon is directly bonded to a metal, compounds in which carbon is bonded to a metal via oxygen, and compounds in which carbon is bonded to a metal via nitrogen. All compounds that can be used for conventional atomic layer deposition processes are applicable. Examples of organometallics include organosilicon compounds such as trimethylaminosilane and bisdimethylaminosilane; organozirconium compounds such as trimethylamidozirconium; organotitanium compounds such as titanium isopropoxide and titanium dimethylethylaminotitanium; organogallium compounds such as trimethylgallium; organozinc compounds; organogermanium compounds; and organoaluminum compounds such as trimethylaluminum.

The metal oxide film preferably has a thickness of 5 to 100 nm. A thickness within this range results in sufficient gas barrier properties. For example, if the metal oxide film is a silicon oxide film, it is desirable that the metal oxide film have a thickness of 10 to 50 nm, preferably 20 to 30 nm. If the metal oxide film is an aluminum oxide film, which has been found to have better gas barrier properties than a silicon oxide film, it is desirable that the metal oxide film have a thickness of 5 to 30 nm, preferably 8 to 20 nm.

It is desirable that the metal oxide film be formed on the inner and outer surfaces of the resin container. Although the metal oxide film is deposited over the entire resin container in the method of manufacture described above, the metal oxide film may, if necessary, be provided only on the inner or outer surface using a technique such as masking.

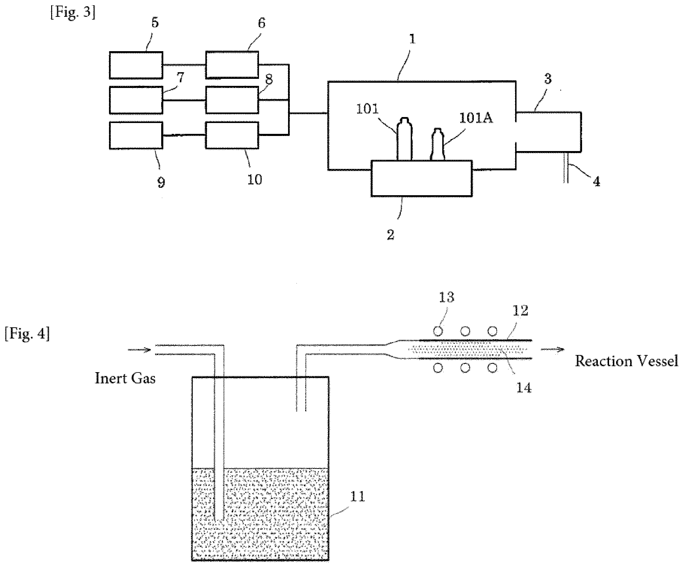

Fig. 3 is a schematic illustration of a resin-container coating apparatus, for forming a metal oxide film on a resin container, according to one embodiment.

The resin-container coating apparatus includes a temperature control stage 2 as a mechanism for maintaining the temperature in a reaction vessel 1 for deposition at greater than 0°C to less than or equal to 150°C, and resin containers 101 and 101A to be treated are placed on the temperature control stage 2. The reaction vessel 1 is connected to an exhaust pump 3 to discharge a gas from the reaction vessel 1 through an exhaust tube 4. An organometallic gas container 5 serving as supply means for supplying a gasified organometallic is also connected to the reaction vessel 1 via a flow rate controller 6. An ozone container 7 serving as means for supplying ozone is also connected via a flow rate controller 8. A water-vapor-gas generation unit 9 serving as plasma-gas supply means for supplying a gas containing water vapor or oxygen and excited with plasma is also connected via an activation unit 10.

The apparatus having the above configuration can be used to form a metal oxide film by, as described above, repeating a series of steps of filling the reaction vessel 1 with a gasified organometallic, introducing an oxidizing gas with increased activity, such as water vapor plasma, and introducing ozone. The ozone supply means does not necessarily have to be provided, and the step of introducing ozone does not necessarily have to be performed.

Fig. 4 is a schematic view of a water-vapor-gas generation unit and an activation unit according to an embodiment. A gas can be humidified through this system by introducing the gas from the left and passing the gas through water in a humidifier 11. The gas used in this case is argon. A radio-frequency magnetic field is applied to the humidified gas in a glass tube 12 by an inductive coil 13 to generate plasma in a region 14. Activated water vapor is generated upon passage through the region 14 and is fed to the reaction vessel 1. For example, the electromagnetic energy applied by the inductive coil 13 is 20 W, and the frequency is 13.56 MHz.

### Examples

### Example 1

A metal oxide film was deposited on the resin container in Fig. 1 using the resin-container coating apparatus in Fig. 3. The resin container 101 was made of a polyethylene terephthalate resin, and a silicon oxide film (silica film) was formed on the surface of the resin container 101.

In this example, trimethylaminosilane was used as an organometallic, and the temperature in the reaction vessel 1 (the resin container 101) was maintained at 23°C.

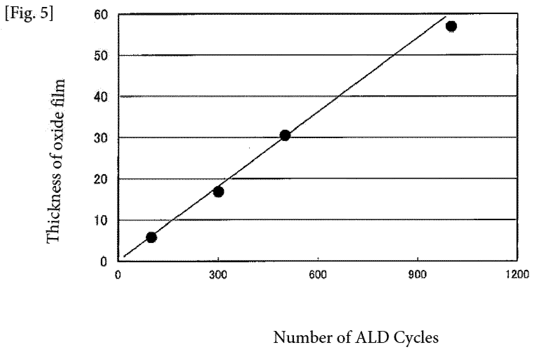

Activated water vapor was first introduced into the reaction vessel 1. The activated water vapor was introduced for 2 minutes. The activated water vapor was generated using the system shown in Fig. 4 by passing argon gas through the water bubbler at a flow rate of 3 sccm while maintaining the water temperature of the water bubbler at 50°C to prepare a humidified argon gas and then activating the water vapor with plasma generated in the glass tube by the inductive coil. The radio-frequency power induced by the inductive coil was 20 W. After the activated water vapor was introduced into the reaction vessel 1, gasified trimethylaminosilane was introduced at 2.3 sccm for 20 seconds. The reaction vessel 1 was then evacuated with the exhaust pump 3. This series of steps is referred to as the ALD cycle. Fig. 5 shows the relationship between the number of ALD cycles and the silicon oxide film formed on the surface of the resin container 101. It was revealed that a silicon oxide film was formed to a thickness of 0.06 nm after a single ALD cycle and that the silicon oxide film was formed in proportion to the number of ALD cycles.

A resin container coated with a 6 nm thick silicon oxide film was fabricated by performing 100 cycles at a deposition rate of 0.06 nm/cycle. The silicon oxide film was formed on both the outer and inner surfaces of the resin container. It was demonstrated that the silicon oxide film had a substantially uniform thickness over the entire resin container and also had a uniform thickness, for example, on the inner surface of the shoulder and at the bottom corner of the resin container, where other methods such as plasma-enhanced CVD would result in poor coverage.

### Example 2

A resin container having a 17 nm thick silicon oxide film was obtained as in Example 1 using trimethylaminosilane as an organometallic.

### Example 3

A resin container having a 30 nm thick silicon oxide film was obtained as in Example 1 using trimethylaminosilane as an organometallic.

### Example 4

A resin container having an 8 nm thick aluminum oxide film (alumina film) was obtained as in Example 1 using trimethylaluminum as an organometallic.

### Comparative Example

A polyethylene terephthalate resin container similar to that of Example 1 but having no metal oxide film formed thereon was provided as a comparative example.

### Test Example 1

The oxygen permeability of Examples 1 to 4 and the Comparative Example was measured with an OX-TRAN 2/61 multi-sample oxygen permeability measurement system (MOCON, Inc.). The measurement was performed in an environment at 23°C and 60% RH (23°C and 0% RH inside the container). A jig equipped with nitrogen gas inlet and outlet tubes was attached to the mouth of each resin container. Air was used as a test gas. Nitrogen was introduced from the inlet tube at 10 cc/min, and the oxygen content of nitrogen discharged from the outlet tube was measured. The measurement results were given as permeability (cc/pkg·day·atm) for each resin container. The results are summarized in Table 1 below. The permeability was converted to 100% oxygen permeability by multiplication with a coefficient of 4.8.

The results showed that Examples 1 to 4, in which a metal oxide film was formed, had a lower oxygen permeability than the Comparative Example, in which no metal oxide film was provided.

The results showed that Example 1, in which a 6 nm thick silicon oxide film was provided, exhibited good gas barrier properties, demonstrating that a uniform silicon oxide film was formed over the entire resin container. For example, an about 6 nm thick silica film formed by plasma-enhanced CVD does not exhibit gas barrier properties.

The results also showed that alumina oxide films have better gas barrier properties than silicon oxide films and that even an 8 nm thick alumina film exhibits better gas barrier properties than the 30 nm thick silicon oxide film of Example 3. It was also demonstrated that even an 8 nm thick alumina film has sufficient gas barrier properties. [Presume this refers to Example 4, since there that is the only alumina film example]

**[Table 1]**

| | Thickness | Permeability cc/pkg·day·atm |
|---|---|---|
| Comparative Example | No film | 0.067 |
| Example 1 | 6 nm (silica) | 0.062 |
| Example 2 | 17 nm (silica) | 0.048 |
| Example 3 | 30 nm (silica) | 0.019 |
| Example 4 | 8 nm (alumina) | 0.002 |

### Reference Signs List

1 reaction vessel
2 temperature control stage
3 exhaust pump
4 exhaust tube
5 organometallic gas container
6 flow rate controller
7 ozone container
8 flow rate controller
9 water-vapor-gas generation unit
10 activation unit
11 humidifier
12 glass tube
13 inductive coil
14 region
100 resin container
100A resin container
101 resin container
101A resin container
102 metal oxide film
102A metal oxide film

## Claims

1. A resin container, comprising:
a metal oxide film formed on at least one of inner and outer surfaces of the resin container,
wherein the metal oxide film comprises a stack of layers of a metal that are deposited on an atomic level, and
wherein the metal oxide film has a thickness of 5 to 100 nm.

2. The resin container according to Claim 1, wherein the metal oxide film is deposited while the resin container is maintained at a temperature of greater than 0°C to less than or equal to 150°C.

3. The resin container according to Claim 1,
wherein the metal oxide film is formed by oxidizing an organometallic compound adsorbed on a surface of the resin container via hydroxy groups with a gas comprising water vapor or oxygen and excited with plasma.

4. The resin container according to Claim 1, wherein the metal is selected from the group consisting of silicon, aluminum, gallium, germanium, titanium, zirconium, and zinc.

5. The resin container according to Claim 1, wherein the metal oxide film is formed on the inner and outer surfaces of the resin container.

6. A resin-container coating apparatus, comprising:
a reaction vessel in which a resin container is supported;
a mechanism that maintains a temperature in the reaction vessel at greater than 0°C to less than or equal to 150°C;
supply means for supplying an organometallic gas to the reaction vessel;
plasma-gas supply means for introducing a gas comprising water vapor or oxygen through a tube that leads to the reaction vessel, the tube comprising a dielectric including glass, the plasma-gas supply means comprising a mechanism that creates a radio-frequency magnetic field in and around the tube to generate plasma in the tube; and
control means configured to repeat
a step of diffusing the organometallic gas supplied from the supply means to allow an organometallic compound to adsorb onto the resin container, and
a step of oxidizing the organometallic compound adsorbed on the resin container with the gas comprising water vapor or oxygen and excited with the plasma, supplied from the plasma-gas supply means.
